Europäisches Patentamt

European Patent Office

Office européen des brevets

(11) Veröffentlichungsnummer: **0 433 825 A1**

# (12) EUROPÄISCHE PATENTANMELDUNG

(21) Anmeldenummer: 90123661.2

(22) Anmeldetag: 08.12.90

(51) Int. Cl.5: **H01L 29/74**, H01L 29/743, H01L 29/08

(30) Priorität: 21.12.89 CH 4576/89

(43) Veröffentlichungstag der Anmeldung: 26.06.91 Patentblatt 91/26

(84) Benannte Vertragsstaaten: CH DE FR GB IT LI SE

(71) Anmelder: **ASEA BROWN BOVERI AG**

**CH-5401 Baden(CH)**

(72) Erfinder: **Bauer, Friedhelm, Dr.**
**Kehlstrasse 2**
**CH-5400 Baden(CH)**

(54) **Abschaltbares Leistungshalbleiter-Bauelement.**

(57) Bei einem abschaltbaren Leistungs-Halbleiterbauelement wird durch Integration eines nichtlinearen, sättigenden Emitter-Ballastwiderstands in das Halbleitersubstrat (19) zwischen dem Emittergebiet (4) und der zugehörigen Metallisierung (1) eine erhöhte Festigkeit gegen Stromfilamentierung beim Abschalten erreicht.

Die Integration lässt sich sowohl bei MCTs als auch bei GTOs problemlos anwenden.

Fig.3

EP 0 433 825 A1

## ABSCHALTBARES LEISTUNGSHALBLEITER-BAUELEMENT

TECHNISCHES GEBIET

Die vorliegende Erfindung bezieht sich auf das Gebiet der Leistungselektronik. Sie betrifft insbesondere ein Leistungshalbleiter-Bauelement, umfassend

(a) innerhalb eines Halbleitersubstrats zwischen einer Anode und einer Kathode eine Vielzahl von nebeneinander angeordneten und parallelgeschalteten ersten Einheitszellen;

(b) innerhalb jeder der ersten Einheitszellen eine Folge unterschiedlich dotierter Schichten, welche Folge eine Emitterschicht, eine zur Emitterschicht entgegengesetzt dotierte erste Basisschicht, eine zur ersten Basisschicht entgegengesetzt dotierte zweite Basisschicht und ein zur zweiten Basisschicht entgegengesetzt dotiertes, in die zweite Basisschicht eingebettetes und mit einem äusseren Kontakt in Verbindung stehendes Emittergebiet einschliesst, und eine Thyristorstruktur bildet; und

(c) innerhalb jeder der ersten Einheitszellen wenigstens einen Emitter-Ballastwiderstand, welcher in die Verbindung zwischen dem Emittergebiet und dem äusseren Kontakt eingefügt ist.

Ein solches Bauelement ist z.B. aus der DE-A1-38 02 050 bekannt.

STAND DER TECHNIK

Der Gate-Turn-Off-Thyristor (GTO) ist heutzutage das "Arbeitspferd" in all den anspruchsvollen Anwendungen der modernen Leistungselektronik, in denen abschaltbare Leistungshalbleiter-Bauelemente benötigt werden. Gleichwohl ist der GTO noch weit davon entfernt, ein idealer Schalter zu sein.

Sein sicherer Betrieb erfordert beispielsweise aufwendige und damit platzraubende und teure Ansteuerungen und Schutzkonzepte. Ein besonderes Problem stellt das Abschalten des Bauelements aus einem Betriebszustand hoher Stromdichte in einen neuen mit hoher Sperrspannung dar.

In dieser Situation beobachtet man das Phänomen der Stromfilamentierung. Man versteht darunter die Ausbildung von Inhomogenitäten der flächenhaften Stromdichteverteilung während des Abschaltvorgangs. Diese können ohne geeignete Schutzmassnahmen ein derartiges Ausmass annehmen, dass das Bauelement durch die entstehende exzessive Stromwärme geschädigt oder ganz zerstört wird.

Um gerade dies zu verhindern, werden in den Schaltkreisen aufwendige und je nach Leistungsklasse auch sehr voluminöse Schutzschaltungen vorgesehen, welche den Spannungsanstieg am Bauelement während des Abschaltens so weit begrenzen, dass die unerwünschten Effekte mit Sicherheit nicht auftreten.

Vom Anwender aus gesehen ist es daher wünschenswert, einen robusteren GTO zur Verfügung zu haben, der bei gleichen Leistungsdaten weniger Aufwand für seinen Schutz benötigt.

Neben den GTOs haben in der Leistungselektronik weiterhin die MOS-gesteuerten Thyristoren (MCTs) grosse Beachtung gefunden (siehe dazu z.B. den Artikel von M. Stoisiek und H. Strack, IEDM Technical Digest, S.158-161, 1985). Sie werden derzeit als potentielle Nachfolger der GTOs angesehen.

Die MCTs besitzen wie die GTOs eine echte Thyristorstruktur. Daher ist auch bei ihnen a priori nicht auszuschliessen, dass es - wie bereits oben im Zusammenhang mit dem GTO beschrieben - beim Abschalten zur Ausbildung von Stromfilamenten kommen kann.

Es ist nun bekannt, dass sogenannte Emitter-Ballastwiderstände zwischen dem eigentlichen $n^+$-Emitter und der Kathodenmetallisierung angeordnet werden können, um eine bereits im Bauelement befindliche, inhomogene Stromdichteverteilung zu homogenisieren, d. h., zu verhindern, dass hieraus ein Stromfilament mit katastrophalen Folgen entstehen kann.

In einer praktischen Realisierung wird jedem Emitterfinger, d.h. jedem der vielen Elementar-Thyristoren, ein Ballastwiderstand zugeordnet. Falls sich dann an einem Finger ein Stromfilament - oder eine Zunahme der Stromdichte - ausbildet, wächst dort lokal der Spannungsabfall über dem Ballastwiderstand. Damit entsteht innerhalb der p-Basisschicht ein Potentialungleichgewicht, welches das entstehende Stromfilament daran hindert, weiter an Stromdichte zuzunehmen.

Für den GTO sind derartige Ballastwiderstände in der eingangs genannten Druckschrift vorgeschlagen worden. Sie werden dort verwirklicht als vergleichsweise hochohmige Schichten, die zwischen den $n^+$-Emittern und der Kathodenmetallisierung eingefügt sind. Die Schichten können dabei beispielsweise aus niedrig dotiertem Polysilizium bestehen.

Derartige Ballastwiderstände in Form von Widerstandsschichten haben jedoch mehrere Nachteile: Zum Einen ist es problematisch, für korrekt dimensionierte Widerstände hinreichend dicke Schichten auf dem Substrat abzuscheiden. Zum Anderen haben diese Widerstände eine lineare Strom-Spannungs-Charakteristik, so dass die erreichte Strombegrenzung nicht sehr effektiv ist.

## DARSTELLUNG DER ERFINDUNG

Aufgabe der vorliegenden Erfindung ist es nun, ein abschaltbares Leistungs-Halbleiterbauelement mit Emitter-Ballastwiderständen zu schaffen, welches die Nachteile der bekannten Bauelemente vermeidet.

Die Aufgabe wird bei einem Leistungs-Halbleiterbauelement der eingangs genannten Art dadurch gelöst, dass

(d) der Emitter-Ballastwiderstand eine nichtlineare, strombegrenzende Charakteristik aufweist; und

(e) in das Halbleitersubstrat integriert ist.

Gemäss einem ersten bevorzugten Ausführungsbeispiel ist der nichtlineare Emitter-Ballastwiderstand als MOSFET vom Verarmungstyp ausgebildet. Dies hat den Vorteil, dass neben einer problemlosen Integration bei diesem Transistortyp bereits bei einer Gatespannung $V_{GS}$ von 0 V ein nennenswerter Stromfluss möglich ist und daher das Gate des Transistors direkt mit der zugehörigen Metallisierung auf der Oberfläche des Halbleitersubstrats verbunden werden kann und damit keine eigene Vorspannung benötigt.

Weitere Ausführungsbeispiele der Erfindung ergeben sich aus den Unteransprüchen.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig.1     eine herkömmliche lineare (a) und eine neue nichtlineare, sättigende (b) Strom-Spannungs-Charakteristik für einen Emitter-Ballastwiderstand;

Fig.2     die Drainstrom-Drainspannungs-Charakteristiken für einen n-Kanal-MOSFET vom Anreicherungstyp (a) und vom Verarmungstyp (b);

Fig.3     ein Ausführungsbeispiel für die Einheitszelle eines Bauelements nach der Erfindung in Form eines p-Kanal-MCT;

Fig.4     zwei beispielhafte Möglichkeiten für die Realisierung des zum MOSFET gemäss Fig.3 gehörenden Kontaktgebietes ohne (a) und mit (b) Emitterkurzschluss;

Fig.5     ein Ausführungsbeispiel für ein Bauelement nach der Erfindung mit zwei verschiedenen, alternierend angeordneten Einheitszellen;

Fig.6     ein Ausführungsbeispiel für die Einheitszelle eines Bauelements nach der Erfindung in Form eines n-Kanal-MCT;

Fig.7     ein Ausführungsbeispiel für ein Bauelement nach der Erfindung in Form eines GTO mit einem Kontaktgebiet gemäss Fig.4a; und

Fig.8     ein zu Fig.7 entsprechender GTO mit einem Kontaktgebiet gemäss Fig.4b.

## WEGE ZUR AUSFÜHRUNG DER ERFINDUNG

Ein zentraler Punkt der Erfindung ist die Ersetzung eines linearen Emitter-Ballastwiderstandes durch einen Widerstand mit einer nichtlinearen, sättigenden Charakteristik.

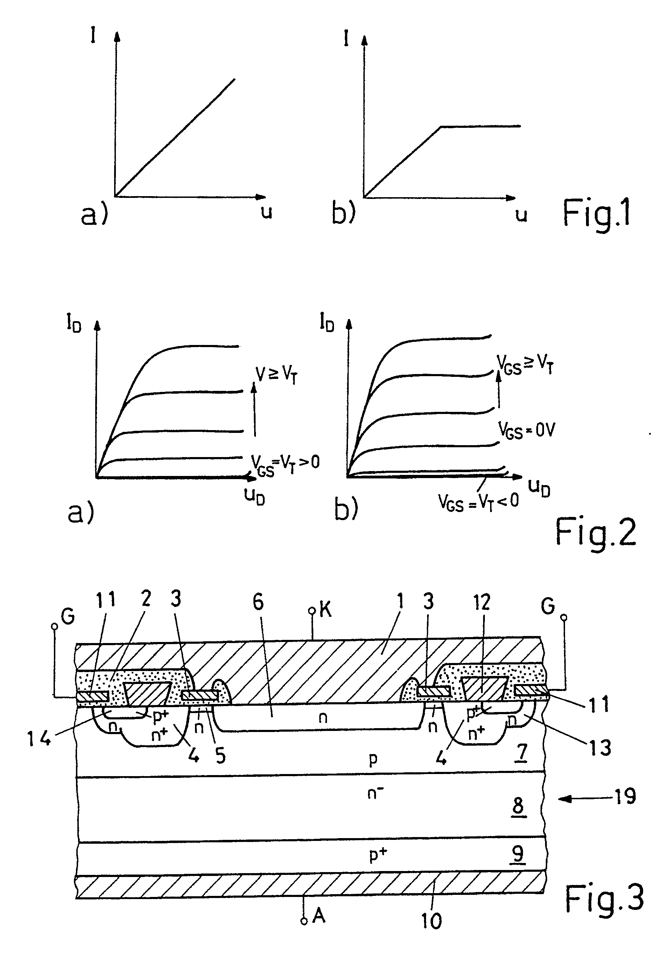

Fig.1 stellt dar, was mit dieser Ersetzung gemeint ist: Während bei den herkömmlichen, als Widerstandsschicht ausgeführten Ballastwiderständen der Strom I über der Spannung U linear verläuft (Fig.1a), wird bei dem erfindungsgemässen Bauelement ein in das Si-Halbleitersubstrat integrierbarer Widerstand verwendet, der prinzipiell die in Fig.1b gezeigte I(U)-Charakteristik mit einem bei höheren Spannungen abflachenden Kurventeil aufweist.

Es ist offensichtlich, dass durch eine solche sättigende Charakteristik die Strombegrenzung innerhalb des Emitters um ein Vielfaches gegenüber der herkömmlichen Realisierung mit linearen Widerständen erhöht wird, so dass das Bauelement deutlich stabiler gegen die Ausbildung von Stromfilamenten wird.

Für die Realisierung eines solchen nichtlinearen Widerstands gemäss einem bevorzugten Ausführungsbeispiel der Erfindung ist nun folgende Ueberlegung bedeutsam: Es ist bekannt, dass Silizium-MOSFETs Drainstrom-Drainspannungs-Charakteristiken mit einer Sättigung besitzen. Die Ausgangskurvenschar (Drainstrom $I_D$ in Abhängigkeit von der Drainspannung $U_D$ mit der Gatespannung $V_{GS}$ als Parameter) eines MOSFETs vom Anreicherungstyp ist in Fig.2a wiedergegeben.

Bei einem n-Kanal-MOSFET vom Anreicherungstyp ist das Substrat und damit auch der Kanalbereich p-dotiert. Diese p-Dotierung bewirkt, dass die Schwellspannung $V_T$ des Transistors - dies ist die Gatespannung, welche überschritten werden muss, um Stromfluss zwischen Source und Drain zu ermöglichen - positive Werte annimmt.

Anders sehen die Verhältnisse aus, wenn der Kanalbereich des MOSFET in geeigneter Weise n-dotiert wird. Diese Kanaldotierung macht aus dem Bauelement einen MOSFET vom Verarmungstyp: die Schwellspannung $V_T$ nimmt nun negative Werte an (Fig.2b). Mit anderen Worten heisst dies, dass in diesem Fall - im Gegensatz zum MOSFET des Anreicherungstyps- bereits ohne angelegte Gatespannung ($V_{GS}$ = 0) nennenswerter Stromfluss möglich ist.

Hierdurch ergibt sich bei der Integration der Vorteil, dass das Gate des MOSFET direkt mit der äusseren Metallisierung des Bauelements verbunden werden kann und keine eigene Gatespannung benötigt.

Ein Ausführungsbeispiel für einen als nichtlinearer Emitter-Ballastwiderstand in einen p-Kanal-MCT integrierten MOSFET vom Verarmungstyp ist in Fig.3 dargestellt.

Zwischen einer Anode A und einer Kathode K ist eine Folge abwechselnd dotierter Schichten angeordnet, die eine Emitterschicht 9 (hier: $p^+$-dotiert), eine erste Basisschicht 8 (hier: $n^-$-dotiert), eine zweite Basisschicht 7 (hier: p-dotiert) und ein Emittergebiet 4 (hier: $n^+$-dotiert) umfasst. Diese Schichtenfolge bildet eine Thyristorstruktur und ist auf der Anodenseite durch eine Anodenmetallisierung 10, auf der Kathodenseite durch eine Kathodenmetallisierung 1 abgeschlossen.

Das Emittergebiet 4 ist in Form eines Ringes ausgebildet. Es ist nicht - wie sonst bei einem Thyristor üblich - direkt mit der Kathodenmetallisierung 1 verbunden, sondern über eine im Inneren des Emitter-Ringes in das Halbleitersubstrat 19 integrierte MOSFET-Struktur.

Die MOSFET-Struktur umfasst einen neben dem Emittergebiet 4 angeordneten, n-dotierten Kanal 5, ein von dem Kanal 5 umschlossenes, ebenfalls n-dotiertes Kontaktgebiet 6 und eine erste Gateelektrode 3, die über dem Kanal 5 durch eine Gateisolierung 2 isoliert angeordnet ist.

Das Kontaktgebiet 6, welches die Source des integrierten MOSFET bildet, ist direkt mit der darüberliegenden Kathodenmetallisierung 1 verbunden. Dasselbe gilt für die erste Gateelektrode 3. Damit ist für den MOSFET stets die Bedingung $V_{GS}$ = 0 erfüllt. Dass dennoch ein nennenswerter Stromfluss vom Emittergebiet 4 über den in Reihe liegenden Transistor zur Kathodenmetallisierung 1 möglich ist, liegt - wie bereits oben erwähnt - daran, dass es sich um einen MOSFET vom Verarmungstyp handelt.

Aufgrund der niedrigen n-Dotierung des zentralen Kontaktgebietes 6, auf welchem der Kontakt zur Kathodenmetallisierung 1 vorgenommen wird, ist sichergestellt, dass dieses Gebiet nicht als Emitter wirken kann.

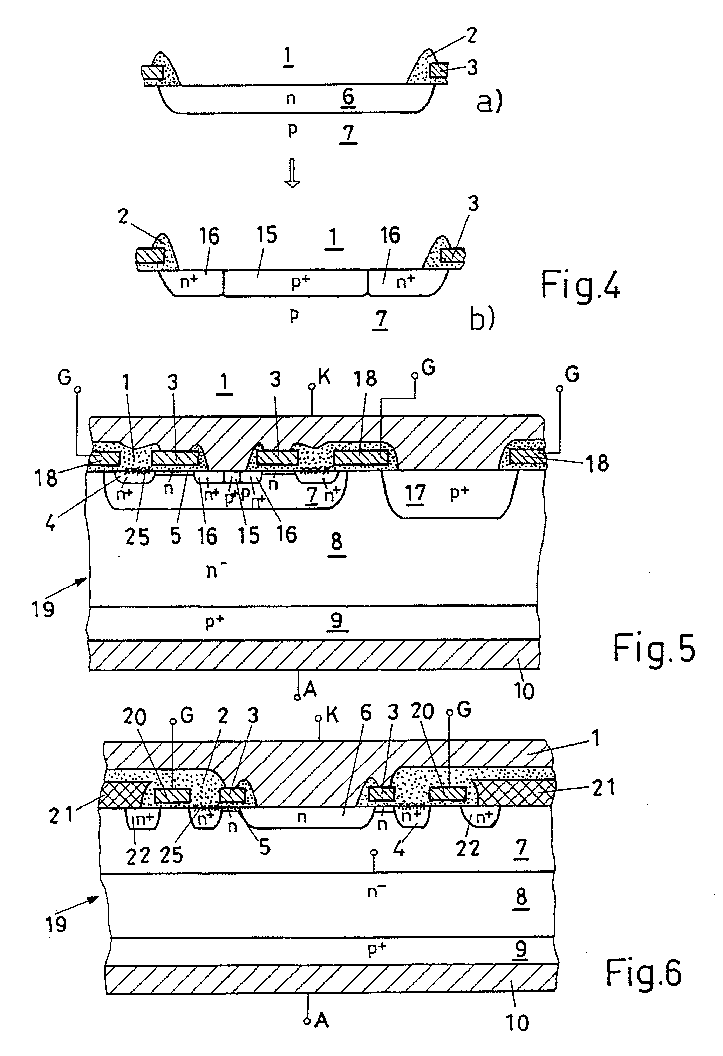

Falls sich der (wegen der niedrigen n-Dotierung) nichtohmsche Kontaktwiderstand störend für die Funktion des gesamten Bauelements auswirken sollte, kann anstelle des einfachen n-dotierten Kontaktgebietes 6 (Fig.4a) ein $n^+$-dotiertes Kontaktgebiet 16 verwendet werden, welches in seinem Innern ein $p^+$-dotiertes, als Emittershort wirkendes Kurzschlussgebiet 15 aufweist (Fig.4b).

Am Aussenrand des Emittergebietes 4 sind in üblicher Weise die MOS-gesteuerten Kurzschlüsse angeordnet, die aus einem $p^+$-dotierten Sourcegebiet 14, einem n-dotierten Kanalgebiet 13 und einer über dem Kanalgebiet 13 isoliert angebrachten zweiten Gateelektrode 11 bestehen.

Der metallische Kurzschluss von Sourcegebiet 14 und Emittergebiet 4 durch eine Metallisierung 12 ist für die Funftion des Bauelements unverzichtbar: Er dient wie bei manchen n-Kanal-MCT-Strukturen als Austauschschicht für den Austausch, d.h. die Rekombination von Elektronen und Löchern.

In den hier beschriebenen Realisierungen muss diese Austauschschicht von der Kathodenmetallisierung 1 isoliert sein. Andernfalls würde der integrierte Emitter-Ballastwiderstand kurzgeschlossen. Aus prozesstechnischen Gründen kann es allerdings angezeigt sein, diese Austauschschicht anstelle der Metallisierung 12 durch ein hochtemperaturstabiles Silizid zu realisieren.

Während beim p-Kanal-MCT der Fig.3 die Sicherheit gegen Stromfilamentierung mit einem relativ hohen prozesstechnischen Aufwand erkauft wird, vereinfacht sich die Herstellung, wenn von der dem Ausführungsbeispiel der Fig.5 zugrundeliegenden Bauelementstruktur ausgegangen wird.

Diese Struktur ist bereits in einer älteren Anmeldung (CH-Patentgesuch Nr. 2945/89-4 vom 10.08.89) vorgeschlagen worden. Sie zeichnet sich durch die parallele, alternierende Anordnung zweier unterschiedlicher Einheitszellen aus: Die erste Einheitszelle (linker Teil der Fig.5) wird gebildet aus der Emitterschicht 9, der ersten Basisschicht 8, der zweiten (jetzt wannenförmigen) Basisschicht 7 und dem Emittergebiet 4. Sie enthält die Struktur eines Thyristors.

Die zweite Einheitszelle (rechter Teil der Fig.5) wird gebildet aus der Emitterschicht 9, der ersten Basisschicht 8 und einem $p^+$-dotierten, wannenförmigen Kontaktgebiet 17.

Zwischen den Einheitszellen sind nacheinander die zweite Basisschicht 7 und die erste Basisschicht 8 an die kathodenseitigeOberfläche des Halbleitersubstrats 19 gezogen und dort von einer isolierten dritten Gateelektrode 18 überdeckt, die gleichzeitig zum Ein- und Ausschalten des Bauelements dient.

Während bei dem Bauelement der älteren Anmeldung sowohl das Emittergebiet 4 als auch das Kontaktgebiet 17 durch die Kathodenmetallisierung 1 direkt kontaktiert werden, ist im Ausführungsbeispiel der Fig.5 wiederum zwischen Kathodenmetallisierung 1 und Emittergebiet 4 die als nichtlinearer Widerstand wirkende, bereits aus Fig.3 bekannte MOSFET-Struktur geschaltet.

In diesem Fall ist der Kathodenkontakt auf einer kombinierten $n^+/p^+$-Zone gemäss Fig.4b vorgenommen. Falls die Grösse des Kontaktloches so gewählt wird, dass der Kontaktwiderstand hinreichend klein bleibt, kann auch hier wieder das Zentralgebiet gemäss Fig.4a einfach n-dotiert werden.

Auch das Bauelement aus Fig.5 erfordert eine Austauschschicht 25 für den Austausch von Elektronen und Löchern, die in diesem Beispiel als Metall- oder besser Silizidschicht über dem Emittergebiet 4 aufgebracht ist (markiert durch Kreuze in Fig.5).

In der oben erwähnten älteren Anmeldung ist auch vorgeschlagen worden, bei der dem Bauelement aus Fig.5 zugrundeliegenden Grundstruktur durch Wiederholung der kathodenseitigen Struktur auf der Anodenseite in sehr einfacher Weise ein bidirektional leit- und sperrfähiges Bauelement zu erzeugen.

Die Emitterschicht 9 wird dabei in der ersten Einheitszelle auf ein wannenförmiges Emittergebiet entsprechend dem Kontaktgebiet 17 reduziert, während in der zweiten Einheitszelle auf der Anodenseite in die erste Basisschicht 8 eine zur zweiten Basisschicht 7 und zum Emittergebiet 4 analoge Struktur eingelassen wird. Die erfindungsgemässen nichtlinearen Emitter-Ballastwiderstände können dann auf beiden Seiten in das Halbleitersubstrat 19 integriert werden.

Weiterhin ist in Fig.6 ein Ausführungsbeispiel für einen n-Kanal-MCT mit integriertem MOSFET-Ballastwiderstand dargestellt. Die schaltbaren Kurzschlüsse werden in diesem Fall durch ein $n^+$-dotiertes Draingebiet 22, eine Metallisierung 21, die zwischen Draingebiet 22 und Emittergebiet an die Oberfläche gezogene zweite Basisschicht 7 und eine darüber isoliert angeordnete vierte Gateelektrode 20 gebildet.

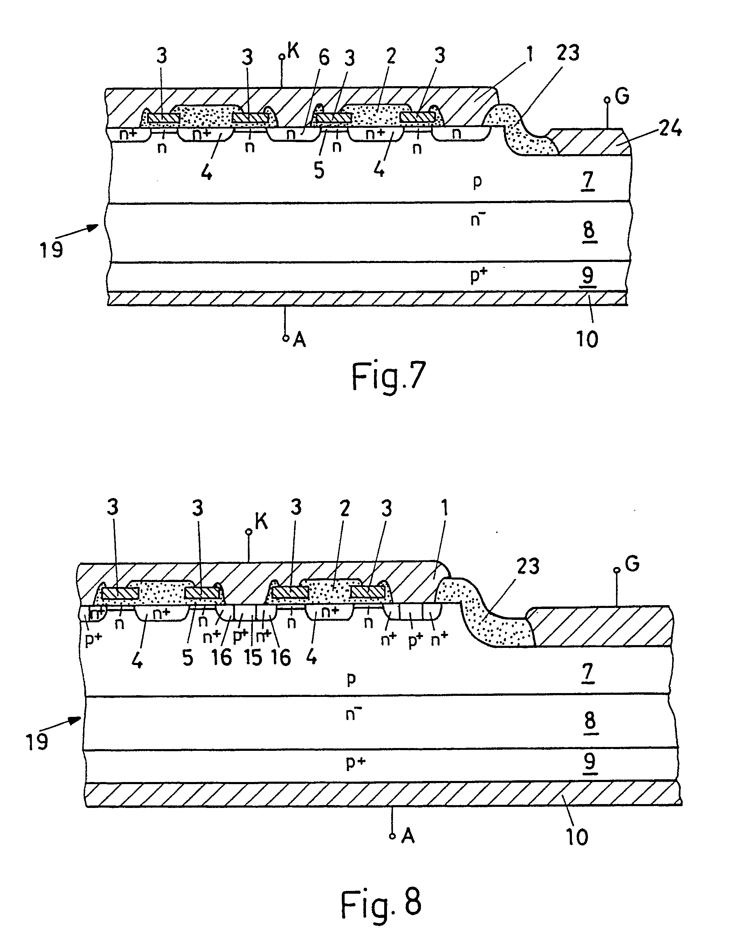

Die Realisierung des nichtlinearen Ballastwiderstandes bei einem GTO ist in zwei Ausführungsbeispielen in den Fig.7 und 8 gezeigt. Zwischen den einzelnen, frei floatenden Emittergebieten 4 in den Emitterfingern sind auch hier n-Kanal-MOSFET-Strukturen integriert, die - Fig.4 entsprechend - entweder ein n-dotiertes Kontaktgebiet 6 (Fig.7) oder ein kombiniertes $n^+/p^+$-Gebiet 15, 16 (Fig.8) beinhalten. Die höherliegende Kathodenmetallisierung 1 ist von einem tieferliegenden Gatekontakt 24 durch eine Trennisolierung 23 elektrisch getrennt.

Wegen der direkten Verbindung zwischen der ersten Gateelektrode 3 und der Kathodenmetallisierung 1 tritt das Gate der MOS-Struktur auch hier nach aussen nicht in Erscheinung,so dass das Bauelement wie jeder herkömmliche GTO nur die drei üblichen Elektroden aufweist.

Schliesslich sei noch darauf hingewiesen, dass im Rahmen der Erfindung auch Bauelemente mit dem nichtlinearen Ballastwiderstand ausgestattet werden können, die zu den Bauelementen der hier beschriebenen Ausführungsbeispiele komplementär dotiert sind.

## Ansprüche

1. Abschaltbares Leistungshalbleiter-Bauelement, umfassend

(a) innerhalb eines Halbleitersubstrats (19) zwischen einer Anode (A) und einer Kathode (K) eine Vielzahl von nebeneinander angeordneten und parallelgeschalteten ersten Einheitszellen;

(b) innerhalb jeder der ersten Einheitszellen eine Folge unterschiedlich dotierter Schichten, welche Folge eine Emitterschicht (9), eine zur Emitterschicht (9) entgegengesetzt dotierte erste Basisschicht (8), eine zur ersten Basisschicht (8) entgegengesetzt dotierte zweite Basisschicht (7) und ein zur zweiten Basisschicht (7) entgegengesetzt dotiertes, in die zweite Basisschicht (7) eingebettetes und mit einem äusseren Kontakt in Verbindung stehendes Emittergebiet (4) einschliesst, und eine Thyristorstruktur bildet; und

(c) innerhalb jeder der ersten Einheitszellen wenigstens einen Emitter-Ballastwiderstand, welcher in die Verbindung zwischen dem Emittergebiet (4) und dem äusseren Kontakt eingefügt ist;

dadurch gekennzeichnet, dass

(d) der Emitter-Ballastwiderstand eine nichtlineare, strombegrenzende Charakteristik aufweist; und

(e) in das Halbleitersubstrat (19) integriert ist.

2. Bauelement nach Anspruch 1, dadurch gekennzeichnet, dass der Emitter-Ballastwiderstand als MOSFET vom Verarmungstyp ausgebildet ist.

3. Bauelement nach Anspruch 2, dadurch gekennzeichnet, dass

(a) die Emitterschicht (9) $p^+$-dotiert, die erste Basisschicht (8) $n^-$-dotiert, die zweite Basisschicht (7) p-dotiert und das Emittergebiet (4) $n^+$-dotiert ist;

(b) der mit dem Emittergebiet (4) in Verbindung stehende äussere Kontakt eine Kathodenmetallisierung (1) ist;

(c) jeder MOSFET aus dem Emittergebiet (4), einem neben dem Emittergebiet (4) angeordneten, n-dotierten Kanal (5), einer über dem Kanal (5) angeordneten ersten Gateelektrode (3) und einem am anderen Ende des Kanals (5) angeordneten, n- oder $n^+$-dotierten Kontaktgebiet (6 oder 16) gebildet wird, wobei der Kanal (5) und das Kontaktgebiet (6 oder 16) in die zweite Basisschicht (7) eingebettet sind; und

(d) die erste Gateelektrode (3) und das Kontaktgebiet (6 oder 16) mit der Kathodenmetallisierung (1) direkt verbunden ist.

4. Bauelement nach Anspruch 3, dadurch gekennzeichnet, dass

    (a) das Kontaktgebiet (16) $n^+$-dotiert ist; und

    (b) das Kontaktgebiet (16) im Innern wenigstens ein $p^+$-dotiertes Kurzschlussgebiet (15) aufweist, welches die oberhalb des Kontaktgebietes (16) angeordnete Kathodenmetallisierung (1) mit der unterhalb des Kontaktgebietes (16) angeordneten zweiten Basisschicht (7) verbindet.

5. Bauelement nach einem Ansprüche 3 und 4, dadurch gekennzeichnet, dass das Bauelement die Struktur eines MOS-gesteuerten Thyristors MCT aufweist.

6. Bauelement nach Anspruch 5, dadurch gekennzeichnet, dass

    (a) das Emittergebiet (4) als Ring ausgebildet ist; und

    (b) der Kanal (5) und das Kontaktgebiet (6 oder 16) im Innern des Ringes angeordnet sind.

7. Bauelement nach Anspruch 6, dadurch gekennzeichnet, dass

    (a) innerhalb des Halbleitersubstrats (19) zwischen der Anode (A) und der Kathode (K) eine Vielzahl von zweiten Einheitszellen vorgesehen sind;

    (b) die ersten und zweiten Einheitszellen abwechselnd nebeneinander angeordnet und parallelgeschaltet sind;

    (c) jede der zweiten Einheitszellen die Emitterschicht (9), die erste Basisschicht (8) und eine auf der Kathodenseite in die erste Basisschicht (8) eingelassenes, zur ersten Basisschicht (8) entgegengesetzt dotiertes Kontaktgebiet (17) umfasst;

    (d) ausserhalb des Emittergebietes (4) die zweite Basisschicht (7), und daran angrenzend zwischen den Einheitszellen die erste Basisschicht (8) an die kathodenseitige Oberfläche des Halbleitersubstrats (19) treten; und

    (e) in diesem Bereich über dem Halbleitersubstrat (19) kathodenseitig isolierte zweite Gateelektroden (18) angeordnet sind.

8. Bauelement nach Anspruch 5, dadurch gekennzeichnet, dass auf der Oberfläche des Halbleitersubstrats (19) über dem Emittergebiet (4) eine Austauschschicht (25) aus einem Metall oder einem Silizid vorgesehen ist.

9. Bauelement nach einem der Ansprüche 3 und 4, dadurch gekennzeichnet, dass das Bauelement die Struktur eines GTO aufweist.

Fig.1

a)

b)

Fig.2

$I_D$

$V \geq V_T$

$V_{GS} = V_T > 0$

$u_D$

a)

$I_D$

$V_{GS} \geq V_T$

$V_{GS} = 0V$

$V_{GS} = V_T < 0$

$u_D$

b)

Fig.3

G    11    2    3    6    K    1    3    12    G

$n^+$    $p^+$    $n^+$    $n$    $n$    $n$    $p^+$    $n^+$

14    4    5    11    13

$p$    7

$n^-$    8    19

$p^+$    9

A    10

Fig.4

Fig.5

Fig.6

Fig.7

Fig. 8

Europäisches
Patentamt

EUROPÄISCHER
RECHERCHENBERICHT

Nummer der Anmeldung

EP 90 12 3661

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-3 230 741 (SIEMENS AG)<br>* Das ganze Dokument<br>* & EP-A-106 059 | 1-3,5 | H 01<br>L 29/74<br>H 01 L 29/743<br>H 01 L 29/08 |
| A | US-A-3 427 511 (ROSENZWEIG)<br>* Das ganze Dokument * | 1,6 | |
| A | DE-A-2 825 794 (LICENTIA PATENT-VERWALTUNGS-GmbH)<br>* Seite 9, Zeile 4 - Seite 10, Zeile 3; Seite 17; Figur 2a * | 1,9 | |
| A | PATENT ABSTRACTS OF JAPAN, Band 13, Nr. 150 (E-742)[3498], 12. April 1989;<br>& JP-A-63 310 171 (HITACHI LTD) 19-12-1988<br>* Zusammenfassung; Figur 1 * | 1,5,7 | |
| D,A | INTERNATIONAL ELECTRON DEVICES MEETING, TECHNICAL DIGEST, Washington, DC, 1.-4. Dezember 1985, Seiten 158-161, IEEE, New York, US; M. STOISIEK et al.: "MOS GTO - A turn off thyristor with MOS-controlled emitter shorts"<br>* Figur 1 * | 1,5,8 | |
| A | EP-A-0 118 785 (ASEA AB)<br>* Seite 4, Zeile 36 - Seite 5, Zeile 1; Figur 1 * | 4 | RECHERCHIERTE SACHGEBIETE (Int. Cl.5)<br><br>H 01 L |
| A | DE-A-2 460 422 (LICENTIA PATENT-VERWALTUNGS-GmbH)<br>* Das ganze Dokument * | 1,2 | |

Der vorliegende Recherchenbericht wurde für alle Patentansprüche erstellt

| Recherchenort | Abschlußdatum der Recherche | Prüfer |
|---|---|---|
| Den Haag | 20 März 91 | MORVAN D.L.D. |